# EUROPÄISCHE PATENTSCHRIFT

(11) **EP 0 360 888 B1**
(45) Veröffentlichungstag und Bekanntmachung des Hinweises auf die Patenterteilung: **18.11.1993**
(21) Anmeldenummer: 88115840.6
(22) Anmeldetag: 26.09.1988
(51) Int. Cl.: H03K 7/08, H02M 3/156

(54) **CMOS-Pulsweitenmodulator**
CMOS pulse width modulator
Modulateur CMOS d'impulsions en durée

(43) Veröffentlichungstag der Anmeldung: 04.04.1990
(73) Patentinhaber: SIEMENS AKTIENGESELLSCHAFT, 80333 München (DE)
(72) Erfinder: Zitta, Heinz, A-9580 Drobollach (AT)

(56) Entgegenhaltungen:
- DE-A- 3 227 296
- US-A- 4 238 695
- ELECTRONIC DESIGN, Band 30, Nr. 14, 8. Juli 1982, Seiten 175-179, Waseca, MN, Denville, NJ, US; J. ALBERKRACK et al.: "Scaling down PWM chip suits low-power switchers"
- RADIO FERNSEHEN ELEKTRONIK, Band 27, Nr. 9, September 1978, Seiten 551-555, VEB Verlag Technik, Berlin, DD; G. TURINSKY: "Schaltungsbeispiele mit CMOS-Schaltkreisen"
- IEEE JOURNAL OF SOLID-STATE CIRCUITS, Band SC-17, Nr. 6, Dezember 1982, Seiten 969-981, IEEE, New York, US; P.R. GRAY et al.: "MOS operational amplifier design - A tutorial overview"
- INTERSIL DATABOOK, Juli 1979, Seiten 6-20 bis 6-24
- NATIONAL SEMICONDUCTOR LINEAR DATA BOOK, 1982, Seiten 9-33, 9-37

## Beschreibung

Die Erfindung betrifft eine Pulsweitenmodulatoranordnung nach dem Oberbegriff des Patentanspruchs 1.

Pulsweitenmodulatoren haben die Aufgabe, eine Spannung eines Oszillators mit zwei verschiedenen Spannungen zu vergleichen und die Vergleichsergebnisse logisch miteinander zu verknüpfen. Pulsweitenmodulatoren werden häufig in Netzgeräten eingesetzt, speziell in Schaltnetzteilen.

Aus der DE-A- 32 27 296 ist die Realisierung eines Pulsweitenmodulators aus zwei Komparatoren mit nachfolgender Logikschaltung in Bipolartechnik bekannt. Beispielsweise wird eine sägezahnförmige Spannung eines Oszillaltors in einem Komparator mit der ersten Vergleichsspannung und im anderen Komparator mit der zweiten Vergleichsspannung verglichen. Die Ausgänge der Komparatoren bilden die Eingänge eines logischen UND-Gliedes, dessen Ausgang der Ausgang des Pulsweitenmodulators ist. Der Ausgang des Logikgliedes ist nur dann aktiv, wenn die erste Vergleichsspannung größer als die sägezahnförmige Spannung und wenn gleichzeitig die zweite Vergleichsspannung ebenfalls größer als die sägezahnförmige Spannung ist. Integrierte Bipolarschaltungen haben grundsätzlich den Nachteil eines großen Flächenbedarfs aufgrund der zu realisierenden Widerstände und einer vergleichsweise großen Verlustleistung aufgrund von Querströmen in den Ausgangskreisen. Eine derartige Schaltung ist nachteilig bei dem Bestreben, in integrierten Schaltkreisen zu einer höheren Integrationsdichte und kürzeren Schaltzeiten zu kommen.

Aus National Semiconductor Linear Data Book, 1982, Seiten 9-33 ff. ist ein integrierter bipolarer Zeitgeberbaustein bekannt, der sich mit einer äußeren Beschaltung als Pulsweitenmodulator eignet. Aus Intersil Data Book, Juli 1979, Seiten 6-20 ff. ist ein integrierter Zeitgeberbaustein mit komplementären MOS-Komparatoren bekannt. Die Ausgangsstufen der Komparatoren sind in PMOS- bzw. NMOS-Technik ausgeführt, denen ein Flip-Flop mit Invertern nachgeschaltet ist. Mit der logischen Verknüpfung der Ausgangsstufen kann ein three-state am Ausgang des Zeitgeberbausteins generiert werden.

Der Erfindung liegt die Aufgabe zugrunde, einen Pulsweitenmodulator mit mehreren Eingängen anzugeben, der die bisher bekannten Lösungen verbessert.

Diese Aufgabe wird bei einer Pulsweitenmodulatoranordnung der eingangs genannten Art erfindungsgemäß durch die Merkmale des kennzeichnenden Teils des Patentanspruchs 1 gelöst.

Die Erfindung besitzt den Vorteil, daß aufgrund der Realisierung in komplementärer MOS-Schaltungstechnik das erforderliche logische Verknüpfungsglied in die Schaltung der Komparatoren einbezogen werden kann. Damit werden keine zusätzlichen Transistoren benötigt, so daß der Flächenbedarf der Schaltung gering ist und die Schaltzeiten kürzer werden.

Weiterbildungen der Erfindung sind in abhängigen Ansprüchen gekennzeichnet.

Die Erfindung wird im folgenden anhand zweier in den Figuren der Zeichnung dargestellten Ausführungsbeispiele näher erläutert. Dabei sind gleiche Elemente mit gleichen Bezugszeichen versehen. Seide Figuren zeigen ein schematisches Schaltbild zweier Komparatoren mit einbezogener logischer Verknüpfung der Ausgangssignale.

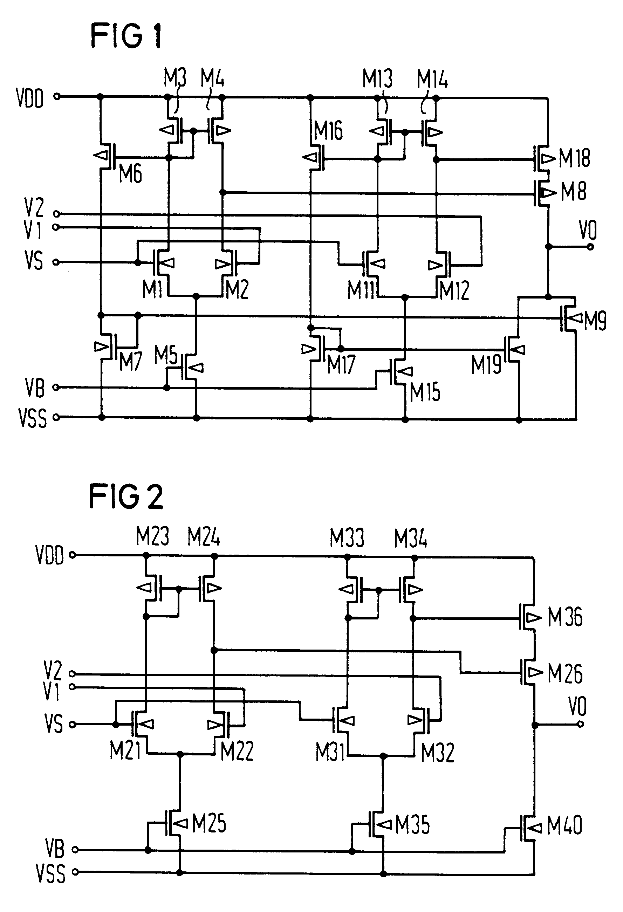

Das Ausführungsbeispiel gemäß Figur 1 geht von einem CMOS-Komparator aus, wie er aus der Veröffentlichung ICC Berlin Continuing Engineering Education Program June 1986, pp. 7.4.1 - 7.4.5 bekannt ist. Eine derartige Komparatorschaltung enthält eine Differenzeingangsstufe aus den Eingangstransistoren M1 und M2, die am gemeinsamen Sourceanschluß von einer Stromquelle M5 versorgt werden und jeweils einen Lasttransistor M3 und M4 treiben. Die Steueranschlüsse der Lasttransistoren sind miteinander und mit dem Drainanschluß des Transistors M3 verbunden. Die Stromquelle wird durch den Transistor M5 realisiert, dessen Steueranschluß über eine Klemme VB von einer Biasspannung gesteuert wird. Dem Komparator nachgeschaltet ist eine Ausgangstreiberschaltung aus einer Referenzstufe mit den Transistoren M6 und M7 und einer Ausgangsstufe mit den Transistoren M8 und M9. Versorgt wird die Komparatorschaltungsanordnung von der Versorgungsspannungsquelle über die Klemmen VDD und VSS. Der Referenztransistor M6 wird vom Verbindungspunkt der Ausgangskreise der Transistoren M1 und M3 gesteuert Der Transistor M7 ist als Diode geschaltet und bildet in Verbindung mit dem Transistor M9 einen Stromspiegel. Der Ausgangstransistor M8 wird vom Ausgang des Komparators an dem Verbindungspunkt der Ausgangskreise der Transistoren M2 und M4 gesteuert.

Der zweite Komparator ist entsprechend dem ersten aufgebaut und enthält die Komparatortransistoren M11 bis M15 sowie die Transistoren M16 bis M19 der Ausgangstreiberschaltung Die Beschaltung der Transistoren M11 bis M19 erfolgt entsprechend der Beschaltung der Transistoren M1 bis M9.

Die an die Komparatoren anzulegende Oszillatorspannung wird über die Klemme VS den Steueranschlüssen der Transistoren M1 und M11 zugeführt. Die beiden Vergleichsspannungen werden einerseits über die Klemme V1 dem Steueranschluß des Transistors M2 und andererseits über die Klemme V2 dem Steueranschluß des Transistors M12 zugeführt.

Erfindungsgemäß werden nun die Ausgangsstufen der beiden Komparatoren zur Realisierung der logischen UND-Verknüpfung ineinandergeschaltet. Dazu werden die Ausgangstransistoren M8 und M18 mit ihren Ausgangskreisen in Reihe geschaltet und die Ausgangskomplementärtransistoren M9 und M19 parallel geschaltet. Der Ausgangsanschluß des Pulsweitenmodulators befindet sich am Verbindungspunkt der Ausgangskreise der Reihenschaltung und der Parallelschaltung der Ausgangsstufe. Die logische Verknüpfung erfolgt dadurch, daß die Ausgangsklemme V0 erst dann auf logischem Eins-Potential liegen kann, wenn sowohl der Ausgang des ersten Komparators den Transistor M8 als auch der Ausgang des zweiten Komparators den Transistor M18 durchgeschaltet haben. Andererseits befindet sich die Ausgangsklemme V0 auf logischem Null-Potential, wenn nur einer der Ausgangskomplementärtransistoren M9 oder M19 angesteuert wird. Die erfindungsgemäße Schaltungsanordnung benötigt die gleiche Anzahl Transistoren wie zwei CMOS-Differentialkomparatoren.

Das gemäß Figur 2 dargestellte Ausführungsbeispiel beruht auf einer CMOS-Komparatorschaltung, wie sie aus der Veröffentlichung IEEE ISSC Vol. Sc-17, No. 6, Dec. 1982, pp. 969-982 bekannt ist. Dabei wird der Komparator entsprechend dem Ausführungsbeispiel der Figur 1 durch die Transistoren M21 bis M25 bzw. M31 bis M35 gebildet. Es ist jedoch als Ausgangstreiberschaltung nur noch eine Ausgangsstufe vorgesehen, die für jeden Komparator einen Ausgangstransistor M26 bzw. M36 und einen Ausgangskomplementärtransistor vorsieht. Während die Ausgangstransistoren von den jeweils zugeordneten Ausgängen des Komparators gesteuert werden, werden die Ausgangskomplementärtransistoren entsprechend den Stromquellentransistoren über die Klemme VB von der Biasspannung gesteuert.

Im Ausführungsbeispiel gemäß FIG 2 sind die beiden Ausgangskomplementärtransistoren durch einen einzigen Ausgangskomplementärtransistor M40 ersetzt. Im übrigen gilt für die logische Verknüpfung der Ausgangssignale der Komparatoren das gleiche wie am Ausführungsbeispiel der Figur 1 erläutert. So sind die Transistoren M26 und M36 mit ihren Ausgangskreisen in Reihe geschaltet, während die Ausgangskomplementärtransistoren parallel geschaltet sind, sofern zwei Transistoren vorgesehen sind. Der Ausgangsanschluß mit der Klemme V0 befindet sich am Verbindungspunkt der Reihenschaltung der Ausgangstransistoren und des bzw. der Ausgangskomplementärtransistoren. Auch dieses Ausführungsbeispiel kommt mit der gleichen bzw. sogar einer geringeren Anzahl Transistoren aus wie zwei einzelne CMOS-Komparatoren.

## Patentansprüche

1. Integrierte Pulsweitenmodulatoranordnung, bei der zwei Komparatoren (M1 bis M5, M11 bis M15; M21 bis M25, M31 bis M35) mit jeweils zugeordneten Ausgangstransistoren (M8, M9, M18, M19; M26, M36, M40) ein Eingangssignal (VS) mit zwei Referenzsignalen (V1, V2) vergleichen und bei der die Vergleichsergebnisse logisch verknüpft werden, **dadurch gekennzeichnet,** daß die Komparatoren und ihre Ausgangstransistoren jeweils in komplementärer MOS-Schaltungstechnik ausgeführt und die Ausgangstransistoren (M8, M9, M18, M19; M26, M36, M40) jedes Komparators zur Durchführung der logischen Verknüpfung zusammengeschaltet sind, wobei zwei an jeweils einen Ausgang der Komparatoren angeschlossene Ausgangstransistoren vom gleichen Typ (M8, M18; M26, M36) in Reihe geschaltet sind und der Verbindungspunkt der Reihenschaltung mit einem zugehörigen komplementären Ausgangstransistor (M9, M19; M40) den Ausgang (V0) der Anordnung bildet.

2. Anordnung nach Anspruch 1, **dadurch gekennzeichnet,** daß die von den Komparatorausgängen gesteuerten Ausgangstransistoren (M8, M18) mit ihren Ausgangskreisen in Reihe und ihre komplementären Ausgangstransistoren (M9, M19) parallel geschaltet sind.

3. Anordnung nach Anspruch 2, **dadurch gekennzeichnet,** daß die komplementären Ausgangstransistoren durch einen als Lastwiderstand geschalteten, zu den Ausgangstransistoren komplementären Transistor (M40) ersetzt sind.

## Claims

1. Integrated pulse width modulator arrangement, in which two comparators (M1 to M5, M11 to M15; M21 to M25, M31 to M35) having respectively assigned output transistors (M8, M9, M18, M19; M26, M36, M40) compare an input signal (VS) with two reference signals (V1, V2) and in which the results of the comparison are logically linked, characterised in that the comparators and their output transistors are in each case configured in complementary MOS circuit technology and the output transistors (M8, M9, M18, M19; M26, M36, M40) of each comparator are interconnected for carrying out the logical linking, two output transistors of the same type (M8, M18; M26, M36), connected to in each case one output of the comparators, being connected in series and the connecting point of the series connection with an associated complementary output transistor (M9, M19; M40) forming the output (V0) of the arrangement.

2. Arrangement according to Claim 1, characterised in that the output transistors (M8, M18) controlled by the comparator outputs are connected in series with their output circuits, and their complementary output transistors (M9, M19) are connected in parallel.

3. Arrangement according to Claim 2, characterised in that the complementary output transistors are replaced by a transistor (M40) which is complementary to the output transistors and is connected as a load resistor.

## Revendications

1. Dispositif modulateur intégré d'impulsions en durée, dans lequel deux comparateurs (M1 à M5, M11 à M15; M21 à M25, M31 à M35), auxquels sont associés respectivement des transistors de sortie (M8,M9,M18,M19;M26,M36,M40), comparent un signal d'entrée (VS) à deux signaux de référence (V1,V2) et dans lequel les résultats de la comparaison sont combinés logiquement, caractérisé par le fait que les comparateurs et leurs transistors de sortie sont réalisés respectivement selon la technique des circuits MOS complémentaires et que les transistors de sortie (M8,M9,M18,M19; M26,M36,M40) de chaque comparateur sont interconnectés pour l'exécution de la combinaison logique, deux transistors de sortie, qui sont raccordés respectivement à une sortie des comparateurs et qui sont du même type (M8,M18;M26,M36), étant branchés en série alors que le point de jonction du circuit série avec le transistor de sortie complémentaire associé (M9,M19; M40) forme la sortie (VO) du dispositif.

2. Dispositif suivant la revendication 1, caractérisé par le fait que les circuits de sortie des transistors de sortie (M8,M18) commandés par les sorties des comparateurs, sont branchés en série et que leurs transistors de sortie complémentaires (M9,M19) sont branchés en parallèle.

3. Dispositif suivant la revendication 2, caractérisé par le fait que les transistors de sortie complémentaires sont remplacés par un transistor (M40) qui est branché en tant que résistance de charge et qui est complémentaire des transistors de sortie.
